# EUROPÄISCHE PATENTSCHRIFT

(11) **EP 0 814 182 B1**
(45) Veröffentlichungstag und Bekanntmachung des Hinweises auf die Patenterteilung: **30.08.2000**
(21) Anmeldenummer: 97108974.3
(22) Anmeldetag: 04.06.1997
(51) Int. Cl.: C25D 5/56, C25D 5/54

(54) **Verfahren zur Herstellung von bahnförmigen metallbeschichteten Folien**
Process for producing strip-shaped metal coated foil
Procédé de fabrication d'une feuille métallisée sous forme de ruban

(30) Priorität: 17.06.1996 DE 19624071
(43) Veröffentlichungstag der Anmeldung: 29.12.1997
(73) Patentinhaber: BAYER AG, 51368 Leverkusen (DE)
(72) Erfinder: Bollens, Louis, 3130 Begijnendijk (BE); Heyvaerts, André, 2620 Hemiksen (BE); Quintens, Dirk, Dr., 2500 Lier (BE); Wolf, Gerhard Dieter, Dr., 41541 Dormagen (DE); Giesecke, Henning, Dr., 51063 Köln (DE); Jonas, Friedrich, Dr., 52066 Aachen (DE)

(56) Entgegenhaltungen:
- EP-A- 0 322 641
- EP-A- 0 329 406
- EP-A- 0 419 845

## Beschreibung

Die Erfindung betrifft die Herstellung von bahnförmigen, mit Metall beschichteten Folien in einem kontinuierlichen "Von Rolle zu Rolle"-Verfahren. Die erfindungsgemäß hergestellten metallbeschichteten Folien zeichnen sich gegenüber anderen bekannten und ebenfalls kontinuierlich herstellbaren metallbeschichteten Folien durch zwei Vorteile aus: Sie enthalten zum einen nicht die üblicherweise eingesetzten Kleberzwischenschichten zwischen Folie und Metallschicht, und sie können zweitens sehr dünne Metallschichten bis herab zu 2-8 µm aufweisen. Auf Grund dieser beiden Vorteile lassen sich aus den erfindungsgemäß hergestellten Folien besonders vorteilhaft miniaturisierte Feinstleiterschaltungen sowie 2-lagige Schaltungen und Multilayer herstellen.

Polyester- und Polyimid-Folien mit aufkaschierten Kupferfolien sind bekannt und werden für die Herstellung von flexiblen Schaltungen und von Folienverbindern in großer Menge hergestellt (Jürgen Bednarz, Kunststoffe in der Elektrotechnik und Elektronik, Verlag W. Kohlhammer, 1988, S. 224 ff.). Diese Laminate enthalten jedoch in der Regel eine Kleberzwischenschicht, die typischerweise 25 bis 50 µm dick ist und beispielsweise aus einem Epoxidharz oder einem Acrylatkleber besteht. Außerdem ist eine Mindestschichtdicke der verwendeten Kupferfolien nötig, um die mechanische Handhabung sicherzustellen. Vielfach werden 18 µm, 35 µm oder 70 µm dicke Kupferfolien eingesetzt. Marktgängig sind auch dünnere Kupferfolien, beispielsweise solche mit 9 µm Dicke, an deren Einsatz gedacht werden könnte. Solche dünnen Folien besitzen aber zusätzlich ein bis zu 9 um dickes treatment und erfordern deshalb ähnlich lange Ätzzeiten wie die gängigen dickeren Kupferfolien. Durch die Kleberzwischenschicht und die recht hohen Kupferschichtdicken bedingt, ist die Herstellung 2-lagiger Schaltungen schwierig und aufwendig, und die Herstellung von Feinstleiterschaltungen hat demnach bezüglich der Breite der einzelnen Leiterbahnen ihre Grenzen. Der Kleber verschmiert weiterhin beim Bohren und muß vor dem Durchkontaktieren im Bohrloch "zurückgeätzt" werden. Der Kleber ist zudem empfindlich gegenüber verschiedenen organischen Lösungsmitteln, die beim Einsatz solcher Leiterbahnen etwa auf so hergestellte Leiterplatten einwirken könnten. Der Wegfall einer Kleberzwischenschicht hätte den Vorteil, daß sich das Produkt noch dünner gestalten ließe und insbesondere bei mehrschichtigen Leiterplatten die zur Zeit sehr starke Ausdehnung von Multilayem in der Z-Schicht vermeidbar wäre. Es ist daher ein Anliegen der vorliegenden Erfindung, solche Nachteile zu vermeiden.

Ein weiteres bekannt gewordenes Verbundmaterial aus Kupferfolie/Kunststoff wird dadurch hergestellt, daß auf den bekannten und oben bereits erwähnten 18 µm oder 35 µm dicken Kupferfolien eine Polyimidschicht durch Aufgießen und Trocknen einer Lösung eines löslichen Polyimids erzeugt wird. Diese Produkte werden beispielsweise unter der Bezeichnung Espanex® von Fa. Rogers, USA, hergestellt und vertrieben. Ähnliche Produkte werden von Fa. Nippon Steel Chemical Co., Ltd. hergestellt. Produkte dieser Art haben gegenüber den weiter obengenannten Laminaten aus Polyimidfolie und Kupferfolie den großen Vorteil, daß sie keine Kleberzwischenschicht enthalten. Jedoch basieren sie nach wie vor nur auf den mechanisch noch gut handhabbaren 18 bzw. 35 µm dicken Kupferfolien und sind dementsprechend für die Herstellung von Feinstleiterschaltungen weniger gut geeignet.

Eine weitere metallbeschichtete Folie mit der Bezeichnung Novoclad® der Fa. Sheldal, USA, besteht aus einer Polyimidfolie, auf die Kupfer aufgesputtert worden ist. Dieses Produkt besitzt den Vorteil einer sehr dünnen Kupferschicht im Hinblick auf die Herstellung von Feinstleiterplatten, jedoch ist die Haftung der Kupferschicht recht gering.

Aus EP-A-0 256 395 (Äquivalent zu US 5.182.135) und EP-A-0 322 641 (Äquivalent zu US 4.910.045) sind Verfahren zur haftfesten Abscheidung von Metallschichten auf Kunststoffoberflächen, beispielsweise Kunststoffolien, beschrieben. Hierzu werden metallisierbare Primer in Form von bindemittelhaltigen Aktivator-Formulierungen auf Kunststoffsubstrate aufgebracht und nach Trocknung und gegebenenfalls Sensibilisierung in chemischen Metallisierungsbädern haftfest mit einer Metallschicht versehen. Diese Verfahren eignen sich sehr gut für die diskontinuierliche Herstellung von flexiblen Schaltungen und Feinstleiterschaltungen; sie sind aber aus folgenden Gründen für einen kontinuierlichen Prozeß nicht geeignet: Für die Herstellung spezieller flexibler Schaltungen ist zwar die Abscheidung einer Kupferschicht mit einer Dicke von 2 µm ausreichend. Um aber eine solche Kupferschicht von 2 µm abzuscheiden, ist eine Verweilzeit in einem chemischen Kupferbad von etwa 1 Stunde erforderlich. Derartig lange Verweilzeiten machen die Übertragung in einen kontinuierlichen Prozeß unmöglich, da entweder eine viel zu niedrige Durchlaufgeschwindigkeit durch das Metallisierungsbad oder aber viel zu große räumliche Ausmaße dieses Bades erforderlich wären.

Es wurde nun gefunden, daß sich bahnförmige Folien kontinuierlich mit Metall beschichten lassen, wenn man metallisierbare Primer in Form von bindemittelhaltigen Aktivator-Formulierungen, wie sie in den obengenannten Schriften EP' 395 und EP' 641 beschrieben sind, verwendet, die Metallisierung aber in zwei Stufen durchführt. Hierbei erfolgt in einer ersten Stufe eine "Anmetallisierung" in einem stromlosen chemischen Metallbad, bis sich eine geschlossene, hinreichend gut leitende Metallschicht gebildet hat, und in einer zweiten Stufe wird eine galvanische Weitermetallisierung, d.h. eine Metallisierung mit Hilfe des elektrischen Stroms mit wesentlich höheren Metallabscheidungsgeschwindigkeiten angeschlossen. Der Erfindung liegt also die neue Erkenntnis zugrunde, daß in einem kontinuierlich ablaufenden Prozeß die langsam ablaufende, stromlose chemische Metallisierung nur in einem solch geringen Ausmaß zu erfolgen braucht, bis eine ausreichend leitfähige Metallschicht gebildet ist, die die Grundlage für die anschließende galvanische Metallisierung bildet. Insbesonders sind spezielle metallisierbare Primer für diesen neuen 2-Stufenprozeß geeignet.

Die erfindungsgemäß metallbeschichteten Folien besitzen die oben beschriebenen Nachteile nicht. So besitzen sie keine Kleberzwischenschichten, weisen nur sehr dünne Metallschichten auf, und die Metallhaftung ist ausgezeichnet, beispielsweise auch nach Lötbadbehandlungen. Somit sind die erfindungsgemäß metallbeschichteten Folien für die Herstellung einseitiger und zweiseitiger, sowie mehrschichtiger Schaltungen verschiedenster Art, von Multilayern und Sensoren, insbesondere aber zur Herstellung von Feinstleiterschaltungen sehr gut geeignet, wobei insbesondere ihre hohe Flexibilität vorteilhaft ist.

Die Erfindung betrifft demnach ein Verfahren zur Herstellung einer bahnförmigen, metallbeschichteten Folie aus einer nicht leitenden Folie durch nacheinander durchgeführtes stromloses und galvanisches Metallisieren, dadurch gekennzeichnet, daß die nicht leitende Folie in einem kontinuierlichen "Von Rolle zu Rolle"-Verfahren folgenden Verfahrensschritten unterworfen wird:
a) Aufgießen eines metallisierbaren Primers, dessen wesentliche Bestandteile
   i) 0,03 bis 2,5 Gew.-% einer (Halb)Edelmetallverbindung,
   ii) 3 bis20 Gew.-% eines organischen polymeren Binders,
   iii) 1 bis 20 Gew.-% eines oder mehrerer Füllstoffe und
   iv) 57,5 bis 95,97 Gew.-% eines halogenfreien Lösungsmittels oder Lösungsmittelgemisches mit einem Flammpunkt oberhalb von 21°C und einem Siedepunkt von mindestens 80°C
   sind, wobei alle Prozentangaben auf das Gesamtgewicht des Primers bezogen sind und wobei der Primer zusätzlich übliche Additive, wie Farbstoffe, Tenside, Verlaufsmittel, Entlüftungsmittel, Verdickungsmittel enthalten kann,
b) Trocknen des aufgebrachten Primers,
c) Konditionieren des aufgebrachten Primers,
d) gegebenenfalls Aktivieren des aufgebrachten Primers,
e) Behandlung mit einem stromlosen chemischen Metallisierungsbad,
f) gegebenenfalls Behandlung mit einer ersten Spülflüssigkeit,
g) Behandlung mit einem galvanischen Metallisierungsbad,
h) Behandlung mit einer zweiten Spülflüssigkeit und
i) gegebenenfalls Temperung der metallisierten Folie.

Als nicht leitende Materialien für die zu beschichtenden Folien kommen beispielsweise in Betracht: Polyethylen-terephthalat, Polybutylen-terephthalat, Polyethylen-naphthat, Polypropylen, Polycarbonat, ABS, Polyetherimid, Polysulfon, Polyethersulfon, Polyimide, Polyamidimide, aromatische, gegebenenfalls Heterocyclen enthaltende Polyamide, wie Polyhydantoin, sowie Blends dieser Polymere. Es können auch Vliese aus Fasern der vorgenannten Polymere eingesetzt werden.

Die Herstellung dieser Materialien und ihre Verarbeitung zu maschinengängigen bahnförmigen Folien ist bekannt. Beispielsweise werden erfindungsgemäß Folien mit Dicken von 12 bis 125 µm, vorzugsweise 50 bis 100 µm, eingesetzt.

Metallisierbare Primer für das erfindungsgemäße Verfahren sind bereits aus Verfahren zur diskontinuierlichen Herstellung von Leiterplatten bekannt. Sie enthalten Verbindungen von Metallen, die als Aktivatoren für die stromlose chemische Metallabscheidung geeignet sind; dies sind im allgemeinen die (Halb)Edelmetalle der Gruppen IB und VIIIB des Periodensystems der Elemente (Mendelejew). Weiterhin enthalten solche Primer einen organischen polymeren Binder, der löslich in organischen Lösungsmitteln oder dispergierbar in wasserhaltigen Formulierungen ist. Weiterhin enthalten solche Primer Lösungsmittel unter Einschluß von Wasser und können zusätzlich Füllstoffe und übliche Additive, wie Farbstoffe, Tenside, Verlaufsmittel, Entlüftungsmittel, Verdickungsmittel u.a. rheologische Additive u.a. enthalten.

Es werden metallisierbare Primer eingesetzt, deren wesentliche Bestandteile
i) 0,03 bis 2,5 Gew.-% einer (Halb)Edelmetallverbindung als Aktivator,
ii) 3 bis 20 Gew.-% eines organischen polymeren Binders,
iii) 1 bis 20 Gew.-% eines oder mehrerer Füllstoffe und
iv) 57,5 bis 95,97 Gew.-% eines halogenfreien Lösungsmittels oder Lösungsmittelgemisches mit einem Flammpunkt oberhalb von 21°C und einem Siedepunkt von mindestens 80°C
sind, wobei alle Prozentangaben auf das Gesamtgewicht des Primers bezogen sind und wobei der Primer zusätzlich übliche Additive, wie Farbstoffe, Tenside, Verlaufsmittel enthalten kann.

Der Bestandteil i) ist ein anorganisches oder organisches Salz, ein Komplexsalz oder eine metallorganische Verbindung der (Halb)Edelmetalle Cu, Ag, Au, Ru, Pd oder Pt, bevorzugt von Ag oder Pd, als Aktivator.

Aktivatoren in Form der genannten Verbindungen von (Halb)Edelmetallen der Nebengruppen IB und VIIIB sind beispielsweise in EP-A-0 034 485, EP-A-0 081 438 und EP-A-0 131 195 beschrieben. Organometallische Verbindungen unter diesen sind beispielsweise solche des Pd, aber auch der anderen (Halb)Edelmetalle, mit Olefinen, Dienen, α,β-ungesättigten Carbonylverbindungen, mit Kronenethern und mit Nitrilen. Vorteilhaft einsetzbare Verbindungen sind beispielsweise Butadien-palladiumdichlorid, Bisacetonitril-palladiumdichlorid, Bis-benzonitril-palladiumdichlorid, 4-Cyclohexen-1,2-dicarbonsäureanhydrid-palladiumdichlorid, Mesityloxid-palladiumdichlorid, 3-Hepten-2-on-palladiumdichlorid und 5-Methyl-2-hexen-2-on-palladiumdichlorid, ohne daß diese Aufzählung erschöpfend ist. Selbstverständlich können auch Gemische solcher Verbindungen eingesetzt werden. Sie können in den Primerformulierungen gelöst oder dispergiert vorliegen. Eine Lösung kann dabei auch durch Zusatz von Lösungsvermittlern hergestellt werden, beispielsweise von quaternären Ammoniumsalzen, wie Tetrabutylammoniumbromid. Bei einer Dispergierung der Aktivatoren ist es vorteilhaft, wenn Teilchengrößen unterhalb von 1 µm erreicht werden.

Als organischer polymerer Binder im erfindungsgemäß anzuwendenden Primer kommt ein aliphatisches, aromatisches oder aliphatisch-aromatisches Polyimid, Polyamidimid, Polyurethan, Polyacrylat oder Epoxidharz in Frage. In bevorzugter Weise werden Polyimide bzw. Polyamidimide oder Polyurethane eingesetzt. Es können aber auch wäßrige Bindemitteldispersionen, beispielsweise auf Acrylat-, Polyurethan- oder Polyesterbasis und Polyolefindispersionen sowie Mischungen solcher Dispersionen verwendet werden.

Unter Polyimiden werden gleichermaßen deren Varianten, wie Polyamidimide, Polyesterimide und Polyetherimide sowie deren Cokondensate und Mischungen verstanden. Die Herstellung ist dem Fachmann grundsätzlich bekannt und erfolgt beispielsweise durch Kondensation von (cyclischen) Polycarbonsäureanhydriden, Polycarbonsäurecarbonsäureanhydriden, Polycarbonsäuren oder deren Estern mit Polyaminen, Polyamiden, Polyisocyanaten oder Polycarbamidsäureestem. Polyimide der genannten Art können als polymere oder als oligomere Imide oder Polyamidsäuren, die nach der Applikation noch auskondensiert werden, eingesetzt werden. Bevorzugt eingesetzt werden aliphatisch-aromatische Polyamidimide, wie sie beispielsweise durch Kondensation von Trimellitsäureanhydrid mit Polyisocyanaten und Lactamen oder Polyamiden erhalten werden (US 4.549.006; US 4.628.079). Vorteilhaft sind beispielsweise Polyamidimide, die aus Trimellitsäureanhydrid, Caprolactam und 4,4'-Diisocyanatodiphenylmethan oder aus Abmischungen von 4,4'-Diisocyanato-diphenylmethan und technischen Gemischen aus 2,4- und 2,6-Toluylendiisocyanaten erhalten werden (US 4.546.162).

Erfindungsgemäß einsetzbare Polyurethane sind grundsätzlich aus der Polyurethanchemie bekannt. Sie werden beispielsweise hergestellt durch Umsetzung von Polyolen mit Isocyanaten, wobei die Polyole ihrerseits Ester und/oder Ether mit endständigen Hydroxylgruppen sein können. Zur Herstellung lagerstabiler Formulierungen ist es weiterhin vorteilhaft, Polyurethane einzusetzen, die keine freien Isocyanatgruppen mehr enthalten. Als geeignet haben sich beispielsweise lineare aromatische Polyurethanelastomere erwiesen, wie sie beispielsweise aus Butandiol-polyadipat, Neopentylglykol und 4,4'-Diphenylmethan-diisocyanat hergestellt werden. Zur Erhöhung der Haftfestigkeit der erfindungsgemäßen Primerformulierungen auf den Oberflächen kann es auch vorteilhaft sein, den Bindemitteln Polyisocyanate oder freie Isocyanatgruppen enthaltende Oligo- oder Polyurethane zuzugeben. Als besonders günstig haben sich hierbei Zusätze erwiesen, die freie, an aliphatische Ketten gebundene Isocyanatgruppen enthalten. Beispiele für geeignete Polyurethane sind: Biuretpolyisocyanate auf Basis von 1,6-Diisocyanato-hexan, Isocyanatgruppen aufweisende Polyisocyanate auf Basis von 1-Isocyanato-3,3,5-trimethyl-5-isocyanatomethyl-cyclohexan und Isocyanuratgruppen aufweisende Polyisocyanate auf Basis von Gemischen von 1,6-Diisocyanato-hexan und 1-Isocyanato-3,3,5-trimethyl-5-isocyanatomethyl-cyclohexan, Biuretgruppen aufweisende Polyisocyanate, wie sie beispielsweise gemäß US 4.264.519 zugänglich sind; Uretdion- und Isocyanuratgruppen aufweisende organische Polyisocyanate, wie sie beispielsweise gemäß EP 173 252 erhalten werden. Bei Verwendung von Polyurethanen mit freien aromatischen Isocyanatgruppen kann es aus Lagerbeständigkeitsgründen günstig sein, die freien Isocyanatgruppen auf bekannte Weise reversibel zu blockieren. Derartige Verfahren sind aus der Polyurethanchemie bekannt. Als Blockierungsmittel können beispielsweise eingesetzt werden: Phenole, Caprolactam, β-Dicarbonylverbindungen, wie Acetessigester und Malonester, bestimmte Alkohole, Oxime und Triazole.

Die Primerformulierungen, die erfindungsgemäß einsetzbar sind, können zusätzlich übliche Additive, wie Farbstoffe, Tenside, Verlaufsmittel u.a. enthalten.

Lösungsmittel mit einem Flammpunkt oberhalb von 21°C und einem Siedepunkt von mindestens 80°C für die erfindungsgemäßen Primerformulierungen sind die in der Druck- bzw. Lackiertechnik bekannten Stoffe aus der Gruppe der aliphatischen und aromatischen Kohlenwasserstoffe, der ein- oder mehrwertigen Alkohole mit 2 bis 8 C-Atomen, der C₃-C₈-Ketone, der Ester von aliphatischen Alkoholen und von Glykolethern mit aliphatischen und aromatischen Carbonsäuren mit 3 bis 12 C-Atomen, der Glykolether mit 3 bis 12 C-Atomen, offenkettige und cyclische Säureamide mit alkylierten N-Atomen mit 3 bis 22 C-Atomen, Lactone mit 4 bis 7 C-Atomen, Diacetonalkohol und Wasser, wie beispielsweise Toluol, Xylol, Benzin, Petrolether; Butanol, Glykol, Glycerin; Aceton, Methylethylketon, Cyclohexanon, Methylisobutylketon; Essigsäurebutylester, Phthalsäuredioctylester, Glykolsäurebutylester; Ethylenglykolmonomethylether, Diglyme, Propylenglykolmonomethylether; Ethylenglykolacetat, Propylenglykolmonomethyletheracetat; Diacetonalkohol sowie Wasser. Selbstverständlich können auch Gemische dieser Lösungsmittel und ihre Verschnitte mit anderen Lösungsmitteln eingesetzt werden. Bei Verwendung von Polyimiden oder Polyamidimiden oder ihren Vorstufen sind insbesondere solche Lösungsmittel vorteilhaft, die diese Polymere lösen oder anquellen. Als Beispiele seien daher folgende weitere Lösungsmittel genannt: Dimethylformamid (DMF), N-Alkylpyrrolidon mit Alkylresten von -CH₃ bis -C₁₈H₃₇, vorzugsweise N-Methyl-pyrrolidon (NMP), Butyrolacton, N-Methyl-caprolactam (NMC), Dimethylacetamid (DMAc) und Hexamethylphosphorsäuretriamid. Diese zuletzt genannten Lösungsmittel können auch als bloße Zusätze, gemeinsam mit anderen Lösungsmitteln eingesetzt werden.

Als Füllstoffe kommen die aus der Druck- bzw. Lackierungstechnik bekannten Hilfsstoffe, wie Pigmente, disperse Kieselsäuren, Tonmineralien, Ruße und reologische Additive in Betracht. Beispiele sind: Aerosile, TiO₂, Talkum, Eisenoxide, Kieselgur, Schwerspat, Kaoline, Quarzmehl, Smectite, Farbruße, Graphite, Zinksulfide, Chromgelb, Bronzen, organische Pigmente und Kreide. Bevorzugt sind Aerosile, Schwerspat und TiO₂. Selbstverständlich sind auch Mischungen der Füllstoffe einsetzbar.

Die Herstellung der erfindungsgemäß einsetzbaren Primerformulierungen erfolgt im allgemeinen durch Vermischen der Bestandteile. Dazu sind neben den einfachen Rührern besonders die in der Lack- und Drucktechnik üblichen Naßzerkleinerungsaggregate, wie Kneter, Attritore, Walzenstühle, Dissolver, Rotor-Stator-Mühlen, Kugelmühlen sowie Rührwerkmühlen geeignet. Selbstverständlich kann das Einarbeiten der Primerbestandteile auch in getrennten Schritten durchgeführt werden. So kann man beispielsweise den Aktivator zuerst in den Bindern und Lösungsmitteln lösen bzw. dispergieren und erst dann die Füllstoffe einarbeiten. Auch ein vorheriges Anteigen der Füllstoffe in den Lösungsmitteln unter hohen Scherkräften ist eine denkbare Verfahrensvariante.

Das Aufbringen des metallisierbaren Primers im Verfahrensschritt a) geschieht durch Aufgießen. Bei der Beschichtung durch Aufgießen werden sehr glatte Schichten, z.B. im Vergleich mit dem Siebdruck erhalten, wie sie besonders zur Herstellung von Feinstleiterschaltungen erwünscht sind. So beträgt beispielsweise die Rauhigkeit Rₘₐₓ einer Kaptonfolie (Kapton® = Polyimid) 1,62 µm, die Rauhigkeit einer getrockneten Primerschicht nach dem Auftragen in Siebdrucktechnik 2,51 µm und die Rauhigkeit einer getrockneten Primerschicht nach dem Aufgießen 2,11 µm. Im Anschluß daran erfolgt der Verfahrensschritt b) des Trocknens des aufgebrachten Primers. Bei diesem Verfahrensschritt b) verringert sich die Dicke der aufgebrachten Primerschicht durch den Verlust des Lösungsmittels. Der ursprünglich aufgebrachte lösungsmittelhaltige Primer wird daher in einer solchen Schichtdicke aufgebracht, daß nach dem Trocknungsschritt eine trockene Primerschicht von 0,5 bis 10 µm, bevorzugt 1 bis 5 µm auf der Folie verbleibt. Der Primer kann hierbei flächig auf die Folie aufgebracht werden oder auch in Form von Mustern, beispielsweise in Form von Leiterbahnen. Für die zuletzt genannte Verfahrensvariante wird statt des flächigen Aufbringens ein Aufdrucken nach verschiedenen Drucktechniken gewählt. Es ist selbstverständlich, daß für die einzelnen genannten Applikationsformen verschiedene Viskositäten der aufzubringenden Primerformulierung gewählt werden: So erfordert das Aufdrucken eine Paste mit höherer Viskosität als das Aufgießen, das Aufsprühen oder das Führen der Folie durch ein Bad der Primerformulierung. Die Viskosität wird im allgemeinen durch die Menge an Lösungsmittel eingestellt. Entsprechend ist die Reduzierung der Schichtdicke der aufgebrachten Primerschicht beim Trocknen verschieden hoch. Selbstverständlich können erfindungsgemäß auch dickere Primerschichten als die genannten aufgebracht werden; es ist jedoch im Sinne der Erfindung, zur Erreichung möglichst flexibler metallisierter Folien möglichst geringe Schichtdicken einzustellen.

Zur Trocknung der beschichteten Folien werden diese bevorzugt durch einen Trocknungskanal geführt, wo sie mit heißer Luft getrocknet werden oder mindestens soweit angetrocknet werden, daß sie auf eine Rolle aufgewickelt werden können. Das Trocknen kann jedoch gleichermaßen auch durch IR-Bestrahlung durchgeführt werden. Im erfindungsgemäßen Sinn wird die bahnförmige Folie zum Applizieren des Primers und zum (An)Trocknen kontinuierlich behandelt, d.h. von einer Rolle abgewickelt, durch die Verfahrensschritte a) und b) geführt und auf eine weitere Rolle wieder aufgewickelt. Die Bahnlänge der sich auf einer Rolle befindlichen Folie kann dabei unterschiedlich groß sein, wie dies dem Fachmann bekannt ist; die Bahnlänge ist jedoch beliebig, so daß sich eine kontinuierliche Verfahrensweise ergibt.

Die beschichtete und (an)getrocknete Folie ist nunmehr grundsätzlich zur stromlosen chemischen Metallisierung bereit. In bevorzugter Weise wird jedoch als Verfahrensschritt c) eine Konditionierung des auf die Folie aufgebrachten Primers durchgeführt. Die Konditionierung ist eine weitere Wärmebehandlung, jedoch bei höherer Temperatur als das vorangegangene Trocknen. Während das Trocknen im allgemeinen bei einer Folientemperatur von 80 bis 110°C erfolgt, wird die Konditionierung bei einer Temperatur von 120°C bis zu einer Temperatur von 10 bis 30°C unterhalb der Wärmefestigkeitsgrenze der Folie durchgeführt. So kann beispielsweise zur Konditionierung einer beschichteten Polyimidfolie eine Behandlung in einem Umlufttrockenkanal bei Temperaturen im Bereich von 230 bis 350°C, bevorzugt 250 bis 320°C, etwa für eine Stunde, durchgeführt werden. Die Konditionierung kann aber auch durch Kontaktbeheizung durch Führung der Folie über eine beheizte Walze bei einer Walzentemperatur von 250 bis 450°C, bevorzugt 375 bis 425°C während einer Zeit von 0,5 bis 5 Minuten, bevorzugt 1 bis 4 Minuten, durchgeführt werden. Schließlich kann auch die Konditionierung ebenso wie die Trocknung durch Beheizung mit IR-Strahlern erfolgen. Hierzu werden Behandlungszeiten und Temperaturen wie bei der Kontaktheizung angewendet. Die Beheizung mit IR-Strahlen wird bevorzugt von der Rückseite, d.h. auf der nicht beschichteten Seite durchgeführt. Für den Fall, daß die zu metallisierende Folie aus Polyester mit einer, verglichen mit Polyimid, niedrigeren Wärmefestigkeitsgrenze besteht, werden Temperaturen im Bereich von 130 bis 200°C angewandt. Für den Fall, daß auch bei Polyesterfolien Kontaktbeheizung bzw. IR-Bestrahlung angewandt werden, werden hierbei Temperaturen von 150 bis 200°C während einer Verweilzeit von 0,5 bis 5 Minuten angewandt. Schließlich kann die Konditionierung als Verfahrensschritt c) auch in einem Trockenschrank erfolgen, wobei die Folie auf der Rolle aufgewickelt bleibt. Die genannten Verfahrensschritte können grundsätzlich so durchgeführt werden, daß die unbeschichtete Folie von einer Rolle abgewickelt wird und durch die Verfahrensschritte a) und b) sowie alternativ zur oben beschriebenen Verfahrensweise anschließend weiter durch den Verfahrensschritt c) geführt wird und ohne erneute Aufwicklung unmittelbar den weiteren erfindungsgemäßen Verfahrensschritten zugeführt wird. Da jedoch die einzelnen Verfahrensschritte unterschiedlich lange Verweilzeiten erfordern, ist es vorteilhaft, nach dem Verfahrensschritt b) der Trocknung die abgewickelte Folie in nunmehr beschichteter und (an)getrockneter Form zunächst wieder, wie oben dargestellt, aufzurollen. Diese wieder aufgerollte beschichtete Folie kann sodann entweder in einem Umlufttrockenschrank während einer Stunde unter den angegebenen Bedingungen konditioniert werden (Verfahrensschritt c)) oder kann erneut abgewickelt werden, durch einen Trockenkanal geführt werden oder durch IR-Bestrahlung oder durch Kontaktbeheizung über eine Walze kontinuierlich weitergeführt und den folgenden Verfahrensschritten zugeführt werden. Eine solche Unterbrechung nach dem Verfahrensschritt b) ist bevorzugt, um den verschieden langen Verweilzeiten Rechnung zu tragen.

Nach der Konditionierung c) werden die beschichteten Folien kontinuierlich durch ein stromloses chemisches Metallisierungsbad als Verfahrensschritt e) geführt. Die Verweilzeit in einem solchen Metallisierungsbad wird so eingestellt, daß sich eine geschlossene, für die nachfolgende galvanische Metallisierung hinreichend leitfähige Metallschicht bildet. Metallisierungsbäder für das erfindungsgemäße Verfahren sind wäßrige Lösungen von Verbindungen der abzuscheidenden Metalle bzw. deren Legierungen, beispielsweise von Cu, Ni, Fe, Co, Pd und anderen, bevorzugt von Cu oder Ni. Die Metallisierungsbäder enthalten weiterhin ein Reduktionsmittel, wie Formaldehyd, Hydrazin oder Aminoborane. Durch diese Reduktionsmittel wird der im Primer vorhandene Aktivator sensibilisiert und anschließend das abzuscheidende Metall reduziert. Für das erfindungsgemäße Verfahren brauchbare Metallisierungsbäder sind bekannt und marktgängig. Es ist jedoch möglich, vor der stromlosen chemischen Metallabscheidung eine separate Aktivierung/Sensibilisierung des abgeschiedenen Primers in einem separaten Bad als Verfahrensschritt d) vor Eintritt in das eigentliche Metallisierungsbad vorzunehmen; eine solche Aktivierung/ Sensibilisierung ist dem Fachmann grundsätzlich bekannt.

Die stromlose chemische Metallisierung wird bei Temperaturen von 20 bis 80°C, bevorzugt 25 bis 70°C, besonders bevorzugt 30 bis 50°C durchgeführt. Die Verweilzeit der mit dem Primer beschichteten Folie im chemischen stromlosen Metallisierungsbad liegt bei 3 bis 30 Minuten, bevorzugt 5 bis 20 Minuten. In einer grundsätzlich bekannten Weise sind diese Verweilzeiten abhängig von der Temperatur der stromlosen chemischen Metallabscheidung und der angestrebten Dicke für eine geschlossene, hinreichend leitfähige Metallschicht. Bei einer Verweilzeit unterhalb von 4 Minuten erreicht man im allgemeinen keine ausreichend leitfähige Metallschicht, die zusätzlich im allgemeinen ungenügend in der Primerschicht verankert ist. Die aus wirtschaftlichen und technischen Gründen angestrebte Dicke der stromlos abgeschiedenen Metallschicht liegt im Bereich von 0,1 bis 3 µm, bevorzugt 0,2 bis 1 µm. Selbstverständlich ist es bei längeren Verweilzeiten möglich, Schichtdicken bis 5 µm oder mehr zu erhalten.

Im Anschluß an die stromlose chemische Metallisierung erfolgt ein einfacher Spülgang, im allgemeinen mit entionisiertem Wasser als einer ersten Spülflüssigkeit (Verfahrensschritt f)).

Nach der Stufe der stromlosen chemischen "Anmetallisierung" folgt der Verfahrensschritt g), nämlich die Behandlung der "anmetallisierten" Folie in einem galvanischen Metallisierungsbad. Hierbei wird bevorzugt vom Verfahrensschritt e), gegebenenfalls unter Zwischenschaltung des Verfahrensschrittes f), in einer "Naß in Naß"-Variante gearbeitet. Selbstverständlich kann auch zwischengetrocknet werden, was ohne Unterbrechung des kontinuierlichen Ablaufs, beispielsweise in einem Trocknungskanal, erfolgen kann. Eine noch weitere Variante besteht darin, nach dem Verfahrensschritt f) ebenfalls in einer Weise den kontinuierlichen Ablauf abzubrechen, wie das weiter oben nach dem Ende des Verfahrensschrittes b) beschrieben worden ist, die soweit behandelte Folie (also nach der stromlosen chemischen Metallisierung und gegebenenfalls nach der Behandlung mit einer Spülflüssigkeit) aufzuwickeln und die so erhaltene Rolle erneut in den kontinuierlichen Ablauf des Verfahrens einzusetzen. Mit Hilfe dieser Unterbrechungen kann, wie oben bereits beschrieben wurde, auf verschiedene Verweilzeiten in einzelnen Verfahrensschritten eingegangen werden.

Die Durchführung des Verfahrensschrittes g), die Behandlung mit einem galvanischen Metallisierungsbad erfolgt in einem marktgängigen und bekannten Metallisierungsbad, aus dem eines der oben für die stromlose Metallisierung genannten Metalle, bevorzugt wiederum Cu oder Ni, abgeschieden wird. Die Folie wird hierzu als Kathode in einen Gleichstromkreis geschaltet, beispielsweise durch Anbringung von Schleifern zur Stromübertragung auf die Metallschicht der Folie.

Als Dicke für diese galvanisch aufgebrachte Metallschicht sei beispielsweise der Bereich von 1 bis 40 µm, bevorzugt 2 bis 10 µm, besonders bevorzugt 2 bis 5 µm genannt. Zur galvanischen Abscheidung werden Stromdichten von 0,2 bis 3 A/dm² angewandt.

Im Rahmen der galvanischen Metallisierung können weiterhin zwei oder mehrere Metallschichten nacheinander aufgetragen werden, indem die "anmetallisierte" Folie durch zwei oder mehrere gleiche oder verschiedene galvanische Metallisierungsbäder geführt wird. Hierbei wird vorzugsweise die Stromdichte in einem ersten Segment der galvanischen Metallisierung im unteren Teil des Gesamtbereiches eingestellt, etwa bei 0,2 bis 1,8 A/dm², während in einem zweiten Segment oder in weiteren Segmenten bei höheren Stromdichten, etwa bei 1,0 bis 3,0 A/dm² gearbeitet wird, so daß von Segment zu Segment eine Erhöhung um 0,8 bis 1,5 A/dm² vorgenommen wird. Im Sinne der späteren Verwendung der metallisierten Folie ist es empfehlenswert, als letzte Metallschicht eine korrosionsbeständige Schicht aufzubringen. Für viele Fälle ist Nickel ausreichend korrosionsbeständig und wird daher vorteilhaft als oberste Metallschicht aufgetragen. Es können aber auch Sn, Pb, Pd oder Au als oberste Schicht oder die Schichtenfolge Ni/Au aufgebracht werden.

Eine weitere Variante des erfindungsgemäßen Verfahrens besteht in der Herstellung beidseitig metallisierter Folien, in dem auch die zweite Seite der Folie gleichzeitig oder nacheinander mit metallisierbarem Primer beaufschlagt und konditioniert wird. Die Metallisierung solcher beidseitig aufgetragener Primerschichten erfolgt sowohl im stromlosen chemischen Metallisierungsbad als auch in einem oder mehreren galvanischen Metallisierungsbädern in bevorzugter Weise gleichzeitig. Selbstverständlich ist es möglich, eine auf einer Seite erfindungsgemäß stromlos und galvanisch metallisierte Folie in einem erneuten Durchgang durch die genannten Verfahrensschritte auf der anderen Seite in erfindungsgemäßer Weise zu metallisieren.

Nach der galvanischen Metallisierung wird in bevorzugter Weise wiederum gespült, beispielsweise erneut mit entionisiertem Wasser als der zweiten Spülflüssigkeit (Verfahrensschritt h)).

Die danach grundsätzlich fertige metallisierte Folie kann noch einer Temperung bei 80 bis 250°C, bevorzugt bei 100 bis 150°C, unterworfen werden. Die gesamte Schichtdicke der stromlos und galvanisch aufgetragenen Metallschicht aus einem oder mehreren Metall(en) beträgt 0,1 bis 70 µm, bevorzugt 2 bis 12 µm, besonders bevorzugt 2 bis 8 µm, wobei im Sinne der Herstellung von Feinstleiterschaltungen der Bereich geringer Schichtdicken der technisch interessantere ist.

Die auf die beschriebene Weise metallisierten Folien eignen sich mit besonderen Vorteilen zur Herstellung einseitiger und zweiseitiger, gegebenenfalls durchkontaktierter flexibler Schaltungen, wozu nach dem Metallisieren durch gezieltes Wegätzen Leiterbahnen herausgebildet werden. Ebenso können Folientastaturen, Folienverbinder und Sensoren, etwa zur Diebstahlsicherung von Wertgegenständen, unterschiedlicher Art hergestellt werden. Die Herstellung kann nach verschiedenen, in der Leiterplattentechnik gebräuchlichen Strukturierungstechniken erfolgen. Die besonderen Vorteile der erfindungsgemäß hergestellten Folien liegen darin, daß sie keine der bislang üblichen Kleberzwischenschichten enthalten und daß sie als Basis für den Leiterbahnenaufbau nur sehr dünne Metallschichten der genannten Dicken aufweisen. Auf diese Weise wird die Herstellung von Schaltungen mit besonders feinen Strukturen begünstigt, bzw. überhaupt erst möglich. Die Anbindung von Chips an Folien in der Mikroverbindungstechnik ist eine weitere Anwendungsmöglichkeit der erfindungsgemäß hergestellten Folien.

### Beispiel 1 (Vergleich)

Aus 4,4'-Diphenylmethan-diisocyanat und Trimellithsäureanhydrid wurde in N-Methylpyrrolidon eine 40 %ige Lösung eines aromatischen Polyamidimids hergestellt. 250 Gew.-Teile dieser 40 %igen Lösung des Polyamidimids, 90 Gew.-Teile Methoxypropylacetat, 2 Gew.-Teile 3-Hepten-2-on-palladiumdichlorid und 15 Gew.-Teile Aerosil® (200 m²/g nach BET) wurden über einen 3-Walzenstuhl sorgfältig miteinander vermischt. Diese Primerformulierung wurde auf einer kontinuierlichen Siebdruckanlage der Fa. Klemm auf eine von einer Rolle abgewickelte Polyimidfolie der Fa. DuPont, Typ Kapton VB 300, mit einer Breite von 300 mm ganzflächig aufgedruckt. Die gedruckte Naßschicht war ca. 6 µm dick. Nach Trocknung in einem Trocknungskanal bei einer Lufttemperatur von 190°C wurde die bedruckte Folie wieder aufgerollt. Die Trockenschichtdicke betrug 1 µm. Die Konditionierung erfolgte durch Führen der Folie über eine beheizte Walze (Kontakttrocknung), die auf ihrer Oberfläche eine Temperatur von 375°C aufwies. Die Ablaufgeschwindigkeit war so eingestellt, daß sich eine Verweilzeit der Folie auf der Walze von 2 Minuten ergab.

Nach der Konditionierung durch Kontakttrocknung erfolgte die chemische Metallisierung kontinuierlich in einem Kupferbad der Fa. MacDermid mit der Bezeichnung XD-6157-T. Badparameter: Cu 2,0 g/l, Formaldehyd 2,0 g/l, NaOH 3,0 g/l, Temperatur 70°C.

Die Durchlaufgeschwindigkeit war auf eine Verweilzeit von 10 Minuten eingestellt. In einer zweiten Metallisierungsstufe wurde ebenfalls kontinuierlich, jedoch galvanisch unter Kontaktierung der vorhandenen Kupferschicht mit elektrischem Strom weiterverkupfert. Als Kupferbad wurde LP 1 der Fa. Blasberg-Oberflächentechnik eingesetzt. In einem ersten Segment der galvanischen Verkupferung wurde mit einer Stromdichte von 0,5 A/dm² (Verweilzeit: 10 Minuten) und in einem zweiten Segment mit einer Stromdichte von 1,5 A/dm² (Verweilzeit: 8 Minuten) gearbeitet. Anschließend wurde mit Wasser gespült, getrocknet und die metallisierte Folie wieder aufgerollt. Die Kupferschichtdicke betrug 2,3 µm.

Die Haftfestigkeit der abgeschiedenen Kupferschicht war ausgezeichnet, sie konnte im Tape-Test nicht abgezogen oder verletzt werden. Nach weiterer galavanischer Verstärkung auf eine Kupferschichtdicke von 35 µm erfolgte der Peelingtest nach DIN 53 494. Es wurden Haftfestigkeitswerte zwischen 1,5 und 2 N/mm ermittelt. Nach einer Behandlung in einem Lötbad von 20 Sekunden bei 288°C wurde im Peelingtest festgestellt, daß keine Abnahme der Haftfestigkeit der Kupferschicht eingetreten war.

### Beispiel 2

Es wurde genauso verfahren wie im Beispiel 1, nur mit dem Unterschied, daß der metallisierbare Primer nicht durch Siebdruck, sondern auf einer Gießmaschine appliziert wurde. Hierzu wurde die im Beispiel 1 angegebene Formulierung durch Verdünnen mit N-Methylpyrrolidon auf einen Feststoffgehalt von 9 % und eine Viskosität von 40 mPa.s eingestellt. Die Naßschichtdicke nach dem Aufgießen betrug ca. 55 µm, die Trockenschichtdicke nach der Trocknung und Konditionierung 5 µm. Die an den metallisierten Folien gefundenen Ergebnisse waren ebenso gut wie die in Beispiel 1 angegebenen.

## Patentansprüche

1. Verfahren zur Herstellung einer bahnförmigen, metallbeschichteten Folie aus einer nicht leitenden Folie durch nacheinander durchgeführtes stromloses und galvanisches Metallisieren, dadurch gekennzeichnet, daß die nicht leitende Folie in einem kontinuierlichen "Von Rolle zu Rolle"-Verfahren folgenden Verfahrensschritten unterworfen wird:
a) Aufgießen eines metallisierbaren Primers, dessen wesentliche Bestandteile
i) 0,03 bis 2,5 Gew.-% einer (Halb)Edelmetallverbindung,
ii) 3 bis 20 Gew.-% eines organischen polymeren Binders,
iii) 1 bis 20 Gew.-% eines oder mehrerer Füllstoffe und
iv) 57,5 bis 95,97 Gew.-% eines halogenfreien Lösungsmittels oder Lösungsmittelgemisches mit einem Flammpunkt oberhalb von 21°C und einem Siedepunkt von mindestens 80°C
sind, wobei alle Prozentangaben auf das Gesamtgewicht des Primers bezogen sind und wobei der Primer zusätzlich übliche Additive, wie Farbstoffe, Tenside, Verlaufsmittel, Entlüftungsmittel, Verdickungsmittel enthalten kann,
b) Trocknen des aufgebrachten Primers,
c) Konditionieren des aufgebrachten Primers,
d) gegebenenfalls Aktivieren des aufgebrachten Primers,
e) Behandlung mit einem stromlosen chemischen Metallisierungsbad,
f) gegebenenfalls Behandlung mit einer ersten Spülflüssigkeit,
g) Behandlung mit einem galvanischen Metallisierungsbad,
h) Behandlung mit einer zweiten Spülflüssigkeit und
i) gegebenenfalls Temperung der metallisierten Folie.

2. Verfahren nach Anspruch 1, dadurch gekennzeichnet, daß als nicht leitende Folie eine aus Polyethylen-terephthalat, Polybutylen-terephthalat, Polyethylennaphthalat, Polypropylen, Polycarbonat, ABS, Polyetherimid, Polysulfon, Polyethersulfon, Polyamidimid, Polyimid, aromatischen, gegebenenfalls Heterocyclen enthaltenden Polyamiden oder einem Blend aus solchen Polymeren oder ein Vlies aus Fasern dieser Polymeren eingesetzt wird.

3. Verfahren nach Anspruch 1, dadurch gekennzeichnet, daß als (Halb)Edelmetallverbindung im Primer ein Salz einer anorganischen oder organischen Säure, ein Komplexsalz oder eine metallorganische Verbindung von Cu, Ag, Au, Ru, Pd oder Pt, bevorzugt von Ag oder Pd eingesetzt wird.

4. Verfahren nach Anspruch 1, dadurch gekennzeichnet, daß als organischer polymerer Binder im Primer ein aliphatisches, aromatisches oder aliphatisch-aromatisches Polyimid, Polyamidimid, Polyurethan, Polyacrylat oder Epoxidharz, bevorzugt ein Polyimid, Polyamidimid oder Polyurethan eingesetzt wird.

5. Verfahren nach Anspruch 1, dadurch gekennzeichnet, daß die aufgebrachte Primerschicht so eingestellt wird, daß nach dem Trocknungsschritt b) eine trockene Primerschicht von 1 bis 10 µm auf der Folie verbleibt.

6. Verfahren nach Anspruch 1, dadurch gekennzeichnet, daß als Verfahrensschritt b) eine Trocknung durch erwärmte Luft oder IR-Bestrahlung und anschließend als Verfahrensschritt c) eine Konditionierung mit Hilfe von erwärmter Luft, IR-Bestrahlung oder Kontaktbeheizung bei einer Temperatur von 120°C bis zu einer Temperatur von 10 bis 30°C unterhalb der Wärmefestigkeitsgrenze der Folie erfolgt.

7. Verfahren nach Anspruch 1, dadurch gekennzeichnet, daß im Verfahrensschritt e) eine stromlose chemische Abscheidung von Cu oder Ni in einer Schichtdicke von 0,1 bis 3 µm, bevorzugt 0,2 bis 1 µm bei einer Verweilzeit im Abscheidebad von 4 bis 20 Minuten, bevorzugt 7 bis 15 Minuten vorgenommen wird.

8. Verfahren nach Anspruch 1, dadurch gekennzeichnet, daß im Verfahrensschritt g) eine galvanische Abscheidung von Cu oder Ni in einer Schichtdicke von 1 bis 40 µm, bevorzugt 2 bis 10 µm, besonders bevorzugt 2 bis 5 µm bei einer Stromdichte von 0,2 bis 3 A/dm² vorgenommen wird.

9. Verfahren nach Anspruch 1, dadurch gekennzeichnet, daß im Verfahrensschritt i) die metallisierte Folie einer Temperung bei 80 bis 250°C, bevorzugt 100-150°C unterworfen wird.

10. Verfahren nach Anspruch 1, dadurch gekennzeichnet, daß das "Von Rolle zu Rolle"-Verfahren nach Schritt b) und/oder Schritt f) unterbrochen wird und mit bis b) bzw. bis f) fertiggestellter, auf Rollen befindlicher Folie auf einer separaten Anlage, beginnend mit Verfahrensschritt c) bzw. g) wiederum kontinuierlich beendet wird.

## Claims

1. Process for the production of a sheet-form, metal-coated film from a non-conducting film by consecutive electroless metallization and electrometallization, characterized in that the non-conducting film is subjected to the following process steps in a continuous "roll-to-roll" process:
a) pouring-on of a metallizable primer whose essential constituents are
i) from 0.03 to 2.5% by weight of a (semi)noble-metal compound,
ii) from 3 to 20% by weight of an organic polymeric binder,
iii) from 1 to 20% by weight of one or more fillers, and
iv) from 57.5 to 95.97% by weight of a halogen-free solvent or solvent mixture having a flash point above 21°C and a boiling point of at least 80°C,
where all percentages are based on the total weight of the primer and where the primer may additionally comprise conventional additives, such as dyes, surfactants, flow-control agents, air-removal agents and thickeners,
b) drying of the applied primer,
c) conditioning of the applied primer,
d) if desired activation of the applied primer,
e) treatment with an electroless chemical metallization bath,
f) if desired treatment with a first rinsing liquid,
g) treatment with an electrometallization bath,
h) treatment with a second rinsing liquid, and
i) if desired heating of the metallized film.

2. Process according to Claim 1, characterized in that the non-conducting film is a polyethylene terephthalate, polybutylene terephthalate, polyethylene naphthalate, polypropylene, polycarbonate, ABS, polyetherimide, polysulphone, polyether sulphone, polyamideimide, polyimide, aromatic polyamides containing heterocyclic radicals, or a blend of such polymers or a nonwoven made from fibres of these polymers.

3. Process according to Claim 1, characterized in that the (semi)noble-metal compound employed in the primer is a salt of an inorganic or organic acid, a complex salt or an organometallic compound of Cu, Ag, Au, Ru, Pd or Pt, preferably of Ag or Pd.

4. Process according to Claim 1, characterized in that the organic polymeric binder employed in the primer is an aliphatic, aromatic or aliphatic-aromatic polyimide, polyamideimide, polyurethane, polyacrylate or epoxy resin, preferably a polyimide, polyamideimide or polyurethane.

5. Process according to Claim 1, characterized in that the applied primer layer is adjusted in such a way that, after the drying step b), a dry primer layer of from 1 to 10 µm remains on the film.

6. Process according to Claim 1, characterized in that, as process step b), drying is carried out by means of warmed air or IR irradiation, and subsequently, as process step c), conditioning is carried out with the aid of warmed air, IR irradiation or contact heating at a temperature of from 120°C to a temperature of from 10 to 30°C below the heat resistance limit of the film.

7. Process according to Claim 1, characterized in that, in process step e), electroless chemical deposition of Cu or Ni is carried out in a layer thickness of from 0.1 to 3 µm, preferably from 0.2 to 1 µm, at a residence time in the deposition bath of from 4 to 20 minutes, preferably from 7 to 15 minutes.

8. Process according to Claim 1, characterized in that, in process step g), electrodeposition of Cu or Ni is carried out in a layer thickness of from 1 to 40 µm, preferably from 2 to 10 µm, particularly preferably from 2 to 5 µm, at a current density of from 0.2 to 3 A/dm².

9. Process according to Claim 1, characterized in that, in process step i), the metallized film is subjected to heating at from 80 to 250°C, preferably 100-150°C.

10. Process according to Claim 1, characterized in that the "roll-to-roll" process is interrupted after step b) and/or step f) and is completed, again continuously, in a separate unit commencing with process step c) or g) respectively with the film on rolls finished up to b) or up to f) respectively.

## Revendications

1. Procédé pour la fabrication d'une feuille métallisée en forme de bande à partir d'une feuille non conductrice par métallisation de type non-électrolytique et par métallisation galvanique mises en oeuvre successivement, caractérisé en ce qu'on soumet la feuille non conductrice dans un procédé en continu "de rouleau à rouleau" aux étapes opératoires ci-après:
a) versage d'une couche de fond métallisable dont les constituants essentiels sont:
i) à concurrence de 0,03 à 2,5% en poids, un composé de métal (semi)noble,
ii) à concurrence de 3 à 20% en poids, un liant polymère organique,
iii)à concurrence de 1 à 20% en poids, une ou plusieurs matières de charge, et
iv) à concurrence de 57,5 à 95,97% en poids, un solvant ou un mélange de solvants exempts d'halogène dont le point d'inflammation est supérieur à 21°C et dont le point d'ébullition s'élève à au moins 80°C,
toutes les indications en pour cent se rapportant au poids total de la couche de fond et la couche de fond pouvant contenir en outre des additifs habituels tels que des colorants, des agents tensioactifs, des agents nivelants, des agents d'élimination de l'air, des épaississants,
b) séchage de la couche de fond appliquée,
c) conditionnement de la couche de fond appliquée,
d) activation le cas échéant de la couche de fond appliquée,
e) traitement avec un bain de métallisation chimique de type non-électrolytique,
f) le cas échéant, traitement avec un premier liquide de rinçage,
g) traitement avec un bain de métallisation galvanique,
h) traitement avec un second liquide de rinçage, et
i) le cas échéant, traitement thermique de la feuille métallisée.

2. Procédé selon la revendication 1, caractérisé en ce qu'on met en oeuvre, à titre de feuille non conductrice, une feuille constituée de polyéthylène-téréphtalate, de polybutylène-téréphtalate, de polyéthylène-naphtalate, de polypropylène, de polycarbonate, de ABS, de polyéther-imide, de polysulfone, de polyéther-sulfone, de polyamidimide, de polyimide, de polyamides aromatiques contenant le cas échéant des composés hétérocycliques ou encore d'un mélange de polymères de ce type ou bien un non-tissé constitué par des fibres de ces polymères.

3. Procédé selon la revendication 1, caractérisé en ce qu'on met en oeuvre, à titre de composé de métal (semi)noble dans la couche de fond, un sel d'un acide inorganique ou organique, un sel complexe ou un composé organométallique de Cu, de Ag, de Au, de Ru, de Pd ou de Pt, de préférence de Ag ou de Pd.

4. Procédé selon la revendication 1, caractérisé en ce qu'on met en oeuvre, à titre de liant polymère organique dans la couche de fond, un polyimide, un polyamidimide, un polyuréthanne, un polyacrylate ou une résine époxy, de préférence un polyimide, un polyamidimide ou un polyuréthanne de type aliphatique, de type aromatique ou de type aliphatique-aromatique.

5. Procédé selon la revendication 1, caractérisé en ce qu'on règle la couche de fond appliquée de telle sorte qu'après l'étape de séchage b), une couche de fond séchée possédant une épaisseur de 1 à 10 µm subsiste sur la feuille.

6. Procédé selon la revendication 1, caractérisé en ce que, à titre d'étape opératoire b), on procède à un séchage via de l'air chauffé ou via exposition à un rayonnement IR et ensuite, à titre d'étape opératoire c), on procède à un conditionnement à l'aide d'air chauffé, d'une exposition à rayonnement IR ou d'un chauffage par contact à une température allant de 120°C jusqu'à une température de 10 à 30°C inférieure à la limite de résistance à la chaleur manifestée par la feuille.

7. Procédé selon la revendication 1, caractérisé en ce que, dans l'étape opératoire c), on procède à une précipitation chimique de type non-électrolytique de Cu ou de Ni pour obtenir une épaisseur de couche de 0,1 à 3 pm, de préférence de 0,2 à 1 µm, et avec un temps de séjour dans le bain de précipitation de 4 à 20 minutes, de préférence de 7 à 15 minutes.

8. Procédé selon la revendication 1, caractérisé en ce que, dans l'étape opératoire g), on procède à une précipitation de type galvanique de Cu ou de Ni pour obtenir une épaisseur de couche de 1 à 40 µm, de préférence de 2 à 10 µm, de manière particulièrement préférée de 2 à 5 µm à une densité de courant de 0,2 à 3 A/dm².

9. Procédé selon la revendication 1, caractérisé en ce que, dans l'étape opératoire i), on soumet la feuille métallisée à un traitement thermique à une température de 80 à 250°C, de préférence de 100 à 150°C.

10. Procédé selon la revendication 1, caractérisé en ce qu'on interrompt le procédé "de rouleau à rouleau" après l'étape b) et/ou après l'étape f) et on le termine à nouveau en continu avec la feuille se trouvant sur les rouleaux et préparée jusqu'à l'étape b), respectivement jusqu'à l'étape f), sur une installation séparée, en commençant avec l'étape opératoire c), respectivement g).
